# EUROPEAN PATENT APPLICATION

(11) **EP 4 546 413 A1**
(43) Date of publication of application: **30.04.2025**
(21) Application number: 23206124.2
(22) Date of filing: 26.10.2023
(51) Int. Cl.: H01L 23/48, H01L 21/48, H01L 23/495, H01L 23/31, H01L 29/20, H01L 29/778

(54) **MOLDED POWER DIE PACKAGE WITH VERTICAL INTERCONNECT**

(71) Applicant: Infineon Technologies Austria AG, 9500 Villach (AT)
(72) Inventor: LEE, Chee Hong, 76450 Paya Rumput (MY); TEY, Lee Siang, 84410 Ledang (MY); HO, Wenn Tze, 75150 Melaka Tengah (MY); SAW KHAY CHWAN, Andrew, 75350 Melaka (MY); LEOW, Chin Kee, 76450 Cheng (MY); MOHAMAD TAHIR, Mohd Rasydan Hakam, 77200 Melaka (MY); RAMLI, Muhammad Izzat, 75350 Batu Berendam (MY); TEO, Poi Siong, 417660 Singapore (SI); TAN, Chee Voon, 70300 Seremban (MY); AROKIASAMY, Xavier, 36000 Teluk Intan (MY); MOHD RAPHEAL, Mohd Saiful Azam, 76100 Durian Tunggal, Melaka (MY); CHA, Chan Lam, 75450 Melaka (MY)
(74) Representative: Lambsdorff & Lange Patentanwälte Partnerschaft mbB

(57) **Abstract**

A power die package includes a power die having a plurality of bond pads at an upper surface of the power die. The package further includes a plurality of contact structures. A contact structure comprises (A) a bond wire bonded to one of the plurality of bond pads and folded back to the bond pad to form a closed loop; or (B) at least three bumps laterally spaced from one another and disposed on one or more bond pads, and a continuous longitudinally extended electrically conductive element connected to the at least three bumps in at least three contact positions, wherein the conductive element bends away from the power die between pairs of consecutive contact positions. The package further comprises a mold compound partially encapsulating the contact structure, wherein the mold compound comprises an outer surface facing away from the power die, and wherein the contact structure is partially exposed at the outer surface.

## Description

### Technical Field

This disclosure relates generally to the field of semiconductor die packaging, and in particular to the field of forming a molded power die package including a package interconnect.

### Background

Semiconductor device manufacturers are constantly striving to increase the performance of their products, while decreasing their cost of manufacture. A cost and device performance sensitive area in the manufacture of a semiconductor device is packaging the semiconductor die. Packaging involves encapsulating the semiconductor die and forming an interconnect from bond pads to package terminals. The packaging concept and interconnect technology should provide for high electrical and thermal performance and reliability of the semiconductor device. They should further support package scalability and die shrinkage.

Power die packages contain a bond pad interconnect to transfer currents between the package terminals and the bond pads on the power die. Increasing currents combined with chip shrinkage are placing ever-increasing demands on the implementation of this package-internal interconnect.

### Summary

According to an aspect of the disclosure, a power die package includes a power die having a plurality of bond pads at an upper surface of the power die. The package further includes a plurality of contact structures. A contact structure comprises (A) a bond wire bonded to one of the plurality of bond pads and folded back to the bond pad to form a closed loop; or (B) at least three bumps placed in a laterally spaced apart relationship on one or multiple bond pads, and a continuous longitudinally extended electrically conductive element connected to the at least three bumps in at least three contact positions, wherein the conductive element bends away from the power die between pairs of consecutive contact positions. The package further comprises a mold compound partially encapsulating the contact structure, wherein the mold compound comprises an outer surface facing away from the power die, and wherein the contact structure is partially exposed at the outer surface.

According to an aspect of the disclosure, a method of manufacturing a power die package comprises providing a power die having a plurality of bond pads at an upper surface of the power die; bonding a plurality of contact structures to the plurality of bond pads of the power die, wherein a contact structure comprises: (A) a bond wire which is bonded to one of the plurality of bond pads and folded back to the bond pad to form a closed loop; or (B) at least three bumps laterally spaced from one another and disposed on one or more bond pads, and a continuous longitudinally extended electrically conductive element which is connected to the at least three bumps in at least three contact positions, wherein the conductive element bends away from the power die between pairs of consecutive contact positions. The method further comprises embedding the power die and the plurality of contact structures in a mold compound such that the mold compound partially encapsulates the contact structure which is partially exposed at an outer surface of the mold compound facing away from the power die.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1A is a schematic cross-sectional view of a power die package including a power die, a mold compound and a plurality of contact structures in accordance with a first example.
Figure 1B is a schematic top view of the power die package of Figure 1A, with the mold compound shown transparent for explanation.
Figure 2A illustrates two schematic cross-sectional views of power die packages (variants I and II) including a power die, a mold compound and a plurality of contact structures in accordance with a second example.
Figure 2B is a schematic top view of the power die packages (variants I and II) of Figure 2A.
Figures 3A-3E are schematic side views illustrating a method of forming contact structures in accordance with the first example (Figures 1A-1B).
Figure 4 is a side view of a contact structure in accordance with the first example (Figures 1A-1B).
Figures 5A-5E are schematic cross-sectional and top views illustrating a method of manufacturing a power die package in accordance with the second example (Figures 2A-2B).
Figure 6 is a top view of a power die to which contact structures in accordance with the second example (Figures 2A-2B) are attached.
Figure 7 is a cross-sectional view of an example of a molded power die package including a leadframe and a mold compound for die embedding.
Figures 8A-8F are schematic cross-sectional views illustrating stages of manufacturing the molded power die package of Figure 7.
Figure 9 is a perspective view of an example of a leadframe for fabricating an example of a molded power die package including multiple dies, for example.
Figures 10A-10D are perspective views illustrating stages of manufacturing a molded power die package including, e.g., multiple dies.
Figure 11 is a perspective view of an example of a molded power die package including, e.g., multiple dies.
Figure 12 is a semi-transparent perspective view of the power die package of Figure 11.
Figure 13 is a semi-transparent perspective view of an example of a power die package including a gate driver semiconductor die embedded in the mold compound.
Figure 14 is a top view of an example of an outer surface of the mold compound of Figure 13 plated with a metal material.
Figure 15A is a perspective view on a top side of the power die package of Figure 13.
Figure 15B is a perspective view on a bottom side of the power die package of Figure 13.

### Detailed description

The words "over" or "on" or "beneath" with regard to a part, element or material layer formed or located or disposed or arranged or placed "over" or "on" or "beneath" a surface may be used herein to mean that the part, element or material layer be located (e.g. placed, formed, arranged, disposed, placed, etc.) "directly on" or "directly under", e.g. in direct contact with, the implied surface. The word "over" or "on" or "beneath" used with regard to a part, element or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

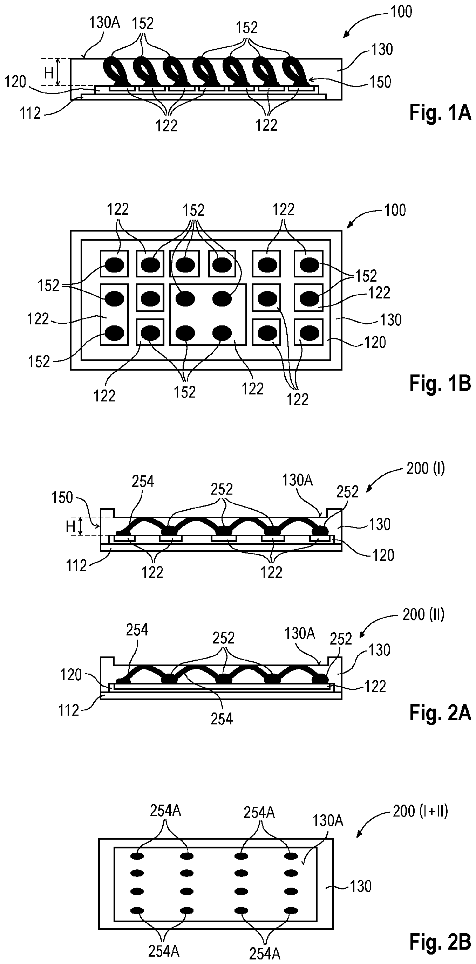

Figures 1A and 1B illustrate a power die package 100 in accordance with a first example. The power die package 100 includes a power die 120. The power die 120 may be mounted on a carrier 112 (also referred to as a die pad or paddle), e.g. on a die pad (paddle) of a leadframe.

The power die 120 may have a plurality of bond pads 122 at an upper surface of the power die 120. A bond pad interconnect 150 is attached to the bond pads 122. The bond pad interconnect 150 includes a plurality of contact structures 152.

The power die package 100 includes a mold compound 130 partially encapsulating the contact structures 152. The mold compound 130 has an outer surface 130A facing away from the power die 120. The contact structure 152 is partially exposed at the outer surface 130A of the mold compound 130.

The bond pad interconnect 150, which includes or is composed of the contact structures 152, is a vertical bond pad interconnect 150. That is, the contact structures 152 are vertical contact structures. Vertical means that the bond pad interconnect 150 (e.g., the contact structures 152 thereof) serves to transports signals and/or currents from or to the bond pads 122 located at the upper surface of the power die 120 to a certain height H above the upper surface of the power die 120. As the contact structures 152 are exposed at the outer surface 130A of the mold compound 130, the signals and/or currents from or to the bond pads 122 are accessible at the outer surface 130A of the mold compound 130.

Referring to Figure 1B, one or a plurality of (vertical) contact structures 152 may be attached to a bond pad 122. In some examples, each bond pad 122 is provided with at least one contact structure 152.

Figures 2A and 2B illustrate two variants I and II of a power die package 200 in accordance with a second example. The power die package 200 includes a power die 120. The power die 120 may be mounted on a carrier 112 (also referred to as a die pad or paddle), e.g., on a die pad (paddle) of a leadframe.

The power die 120 may have one or a plurality of bond pads 122 at an upper surface of the power die 120. A bond pad interconnect 150 is attached to the bond pads 122. The bond pad interconnect 150 includes a plurality of contact structures.

In the second example, the contact structure includes at least three bumps 252 laterally spaced from one another and disposed on one or more bond pads 122. The contact structure of the bond pad interconnect 150 further includes a continuous longitudinally extended electrically conductive element 254 connected to the at least three bumps 252 in at least three contact positions, wherein the conductive element 254 bends away from the power die 120 between pairs of consecutive contact positions.

In variant (I), each bump 252 is placed on a separate bond pad 122. That way, separate bond pads 122 are connected by the conductive element 254. In contrast, in variant (II), a single bond pad 122 is provided with a plurality of bumps 252. That way, a conductive element 254 may be connected only to a single (continuous) bond pad 122.

As in the first example, in both variants (I) and (II) of the second example, the bumps 252 provide cushion when applying the conductive element 254 to the bumps 252. For example, if the conductive element 254 is a bond wire dispensed by a capillary, the bumps 252 protect the bond pad(s) 122 from being directly contacted by the capillary.

In both variants (I) and (II), the bumps 252 and the conductive element 254 provide the vertical nature of the bond pad interconnect 150, i.e. the ability to "lift" the connectivity level of the power die 120 from its upper surface to the outer surface 130A of the mold compound 130 at height H. The height H can be selected by appropriately setting the amplitude of the wavy-line type conductive element 254. The contact structures 252, 254 may be referred to as wavy-line type contact structure. The continuous longitudinally extended electrically conductive element 254 may, e.g., be a bond wire or a bond ribbon.

As described previously, the power die package 200 includes a mold compound 130 partially encapsulating the contact structures 152. The mold compound 130 has an outer surface 130A facing away from the power die 120. The contact structure 152 is partially exposed at the outer surface 130A of the mold compound 130 (see Figure 2B, which applies to both variants I and II).

For example, the height H of the Escargot type contact structure 152 in package 100 or of the wavy-line type contact structure 252, 254 in package 200 is in a range between 70 µm and 200 pm, in particular between 100 µm and 150 µm.

Examples described herein provide a power die package 100, 200 and methods of manufacturing that may allow for advantages over known packages and/or processes such as greater flexibility in the height H of the (vertical) bond pad interconnect 150, a reduction in manufacturing time and/or cost and/or the application of less stress to the power die and/or the bond pads 122 during the formation of the bond pad interconnect 150.

Moreover, a greater vertical interconnect height H may be achieved compared to conventional vertical interconnect structures such as, e.g., copper pillars, vertical wires or multiple stud bums. Copper pillars are limited in height to about 70 µm and growing copper pillars is costly especially for larger dies. Vertical wires can reach great heights but have limitations in terms of stiffness and UPH (units per hour) requirements. Stacking multiple stud bumps stresses the die and bond pads thereon and is limited in height since stacking more than 2 or 3 stud bumps is too costly.

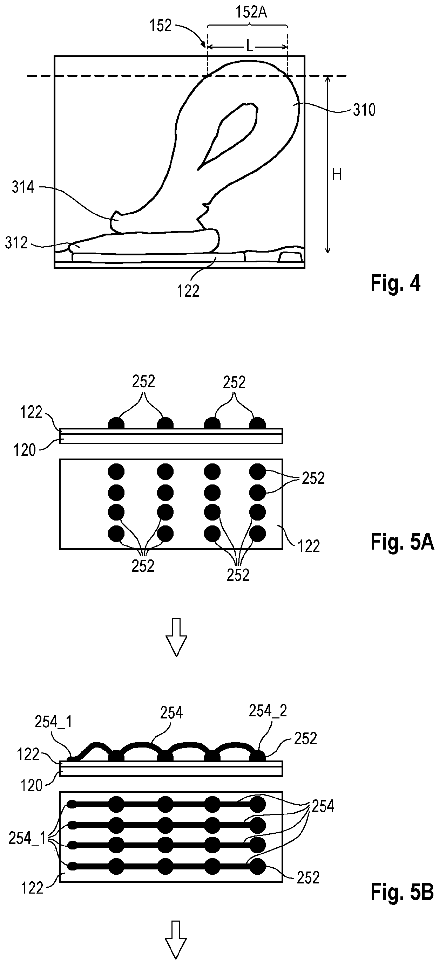

As to the first example (Figures 1A-1B), bonding a bond wire to a bond pad 122 and looping it back to the bond pad 122 is a process which is cheaper and about 1.3 times faster compared to the process of stacking multiple stud bumps on a bond pad 122. The process allows easy control on exposed surface area A (see Figure 4) of the wire loop and on loop height H. Further, the wire loop direction may easily be manipulated, e.g. oriented in different (e.g., opposite) directions.

In view of the second example (Figures 2A-2B), attaching the conductive element 254 to a bump 252 provided on a contact pad 122 of a power die 120 in at least three contact positions using a wire or ribbon bonding process is faster and cheaper compared to the process of stacking multiple stud bumps at the same number of contact positions. Similarly, the various examples may also be faster compared to attaching multiple vertical wires, where a pre-cut step prior to bonding is typically required in order to ensure uniform wire length.

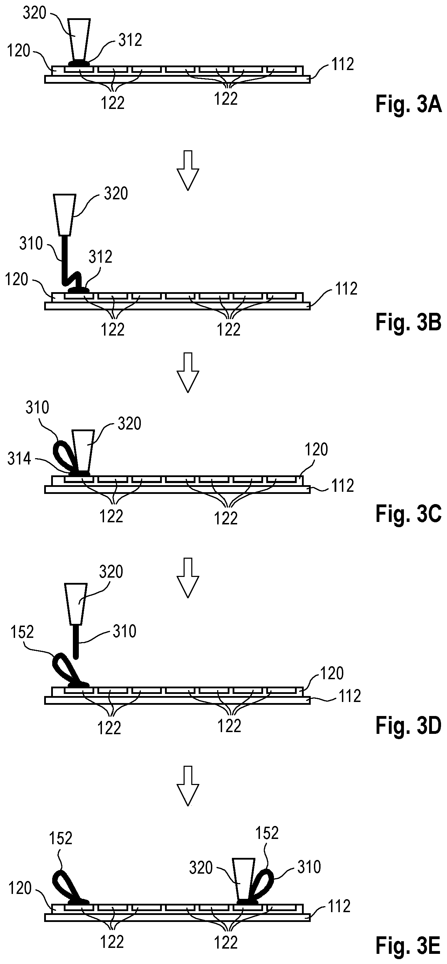

Figures 3A-3E illustrate schematic side views of a method of forming contact structures 152 in accordance with the first example (Figures 1A-1B). The formation process may, e.g., be as follows: First, a ball may be formed, e.g., by means of a discharge spark, on a tip end of a wire 310 that passes through a capillary 320. Referring to Figure 3A, the capillary 320 is then lowered and the ball is joined to the surface of the bond pad 122. A first bond 312 (see also Figure 4) on a bond pad 122 is formed by, e.g., hot press-bonding or ultrasonic vibration, etc.

Then, referring to Figure 3B-3C, the capillary 320 is lifted, moved in a loop and lowered so that the wire 310 is folded back to the bond pad 122 to connect again to the first bond 312 on the bond pad 122. In other words, a second bond 314 is formed on the first bond 312. The wire 310 forms a loop having, e.g., an inverted U shape at its upper portion.

Referring to Figure 3D, after the second bond 314 is completed, the wire 310 may be cut. In regard to the shape of the looped wire 310, this type of (vertical) contact structure 152 is also referred to as an Escargot type contact structure.

Referring to Figure 3E, additional contact structures 152 may be placed on the same or other bond pads 122. For example, the loop of the contact structure 152 may have a certain loop direction which is inclined in relation to the surface of the bond pad 122. The degree of inclination may be controlled by the bonding process, i.e. the trajectory of the capillary 320 when moved to form the loop. More specifically, the loop direction (direction of inclination of the contact structure 152) may be manipulated by controlling the position of the second bond 314 on the first bond 312.

In some examples, the loop direction of the contact structure 152 may change from one bond pad 122 to another bond pad 122 (e.g., Figure 3E). In particular, the loop direction of the contact structures 152 may alternate for consecutive contact structures 152 and/or consecutive bond pads 122.

Referring to Figure 4 a side view of an Escargot type contact structure 152 is shown. Loop heights H of 110 µm and 150 µm had been set, for example. It has been shown that a consistent loop height H with a standard deviation of only about 3 µm could be achieved. Further, the loop inclination and/or the exposed area 152A of contact structure 152 could be controlled with high reproducibility. For example, the length L of the exposed area 152A of the looped wire 310 may, e.g., be set in a range between 10 µm and 70 pm, in particular 30 µm and 50 µm.

Figures 5A-5E are schematic cross-sectional views (upper portion of the respective Figure) and top views (lower portion of the respective Figure) illustrating a method of manufacturing a power die package 200 in accordance with the second example (Figures 2A-2B). For example, the method is described for variant (II), where bonding is performed on a single bond pad 122. However, the following disclosure is also applicable to variant (I), and reiteration is omitted for the sake of brevity.

As shown in Figure 5A, (stud) bump bonding is performed first. At least three bumps 252 are placed on the bond pad 122. The bumps 252 are laterally spaced apart from one another. The position of the bumps 252 on the contact pad 122 may define the contact positions for the electrically conductive element 254 to be connected to the at least three bumps 252. If a plurality of electrically conductive elements 254 is to be connected to the at least three bumps 252 in at least three contact positions, multiple rows of bumps 252, e.g. an array of bumps 252, may be provided. The bumps 252 may be distributed on the contact pad 122 in a regula pattern, e.g. in row(s) or array(s) of regular pitch.

Bump bonding may be performed by any conventional bump formation processes. For example, a ball may be formed at the tip of a wire 310 (see Figure 3A, for example) and joined to the surface of the bond pad 122 by lowering a capillary 320 as described above and, e.g., by hot press-bonding or ultrasonic vibration. The wire 310 is then disconnected from the bump 252 by, e.g., horizontal and vertical movements of the capillary 320.

Referring to Figure 5B, the conductive element(s) 254 (e.g., one or multiple ribbons or wires) may then be attached to the bumps 252. Each conductive element 254 is attached to at least three (in the example shown, four) bumps 252. The bumps 252 to which the conductive element 254 is attached may be arranged in a (linear) row, for example.

For example, the process of attaching the conductive element 254 to the bumps 252 may optionally start with a process of bonding one end 254_1 of the conductive element 254 directly to the bond pad 122. The conductive element 254 is then connected to the pre-positioned bumps 252 at contact positions defined by the position of the bumps 252.

A length of the conductive element 254 between consecutive contact positions may be larger than a separation of the consecutive contact positions. For example, the conductive element 254 may have a wave-like pattern with multiple inflection points. The contact positions may be located at lower inflection points of the conductive element 254. Upper inflection points of the conductive element may define the height H of the vertical contact structure 152, which is formed by bumps 252 and conductive element 254. As a consequence, the conductive element 254 may bend away from the contact pad 122 between pairs of consecutive contact positions. The term "consecutive" contact positions may refer to contact positions that follow each other along the length of the continuous longitudinally extended conductive element 254.

In various embodiments, the continuous longitudinally extended electrically conductive element 254 may be shaped during the attachment process to form the contact structure 152 that bends away from the contact pad 122. In other embodiments, the conductive element 254 may, e.g., be pre-formed such that the attachment process is done with a preformed conductive element 254.

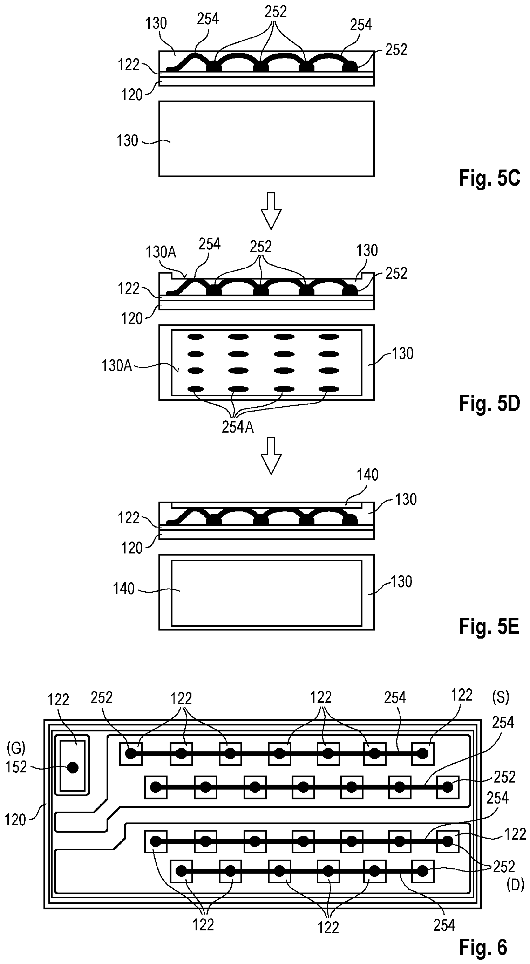

Referring to Figures 5C and 5D, the attached contact structure 252, 254 may subsequently be partially encapsulated by the mold compound 130. The mold compound 130 leaves a area 254A of the contact structure 252, 254 exposed (Figure 5D). Alternatively, the mold compound 130 may initially completely encapsulate the contact structure 252, 254 (Figure 5C), and may subsequently be partially removed to expose the contact structure 252, 254 at an outer surface 130A of the mold compound 130 (Figure 5D). Methods such as grinding, etching or laser processing may be used for partial removal of the mold compound 130. Depending on the processes used, upper portions of the contact structure 252, 254 (e.g., the electrically conductive element 254) may be left intact or may be removed. In the former case, if the contact structure 252, 254 uses continuous longitudinally extended electrically conductive elements 254 as shown in Figures 2A, 2B, 5A-5D, the electrically conductive elements 254 may still be continuous, and in the latter case they may form individual segments.

Subsequently, metal pads and/or metal traces 140 may be formed onto the outer surface 130A of the mold compound 130 in contact with exposed area 254A of the contact structure 252, 254. The metal material may have a thickness in a range between 30 µm and 100 µm, for example.

In both examples, the bond pad interconnect 150 may use bond wires (either for forming the Escargot type contact structure 152 or as the conductive element 254 of the wavy-line type contact structure 252, 254). The bond wire 310 may, e.g., comprise or be of Cu or Au. The diameter of the bond wire 310 may, e.g., be in a range between 10 µm and 70 pm, in particular between 30 µm and 50 µm.

Further, in both examples, the current capability of the contact structures 125, 252, 254 is enhanced in comparison to contact structures formed of single wires, stud bumps or pillars.

For example, the mold compound 130 is a laser-activatable mold compound. In this case, the mold compound 130 has at least one laser-activated region which is plated with a metal material to form the metal pad and/or a metal trace 140 at the outer surface 130A of the mold compound 130.

The laser-activated region of the mold compound 130 may be generated by using a laser direct structuring (LDS) process. In some examples, a LDS process may be used both for partial removal of mold compound material and activation of the mold compound 130 to form the laser-activated regions in the mold compound 130.

For example, a laser-activatable mold compound 130 may include at least one additive, e.g., in the form of an organic metal complex which is activatable by a physiochemical reaction induced by laser processing. The laser induced physio-chemical reaction causes metal atoms to be freed from the metal complex thereby acting as a nuclei for the deposition of metal or metal alloys (e.g., Cu, Ni, NiP, Au, Cu/Ni/Au stack, etc.) by, e.g., plating or coating in the regions of the mold compound activated by a laser (i.e., the laser-activated regions).

Figure 6 illustrates a top view of a power die 120 to which contact structures 252, 254 in accordance with the second example (Figures 2A-2B, 5A-5E) are attached. The power die 120 is provided with bond pads 122 at its upper surface, for example, at least one (here: two) rows of source (S) bond pads 122, at least one (here: two) rows of drain (D) bond pads 122 and a gate (G) bond pad 122. As shown in Figure 6, the source (S) bond pads 122 are interconnected by conductive elements 254. Similarly, the drain (D) bond pads 122 are interconnected by conductive elements 254. The gate (G) bond pad 122 may, e.g., provided with an Escargot type contact structure 152.

In all examples, the power die 120 comprises or is of a semiconductor material. Examples of such semiconductor materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AlInN), indium gallium nitride (InGaN), aluminum gallium indium nitride (AlGaInN) or indium gallium arsenide phosphide (InGaAsP), etc.

In some examples described herein, the power die 120 may, e.g., be a horizontal semiconductor device, meaning that the device is configured to conduct a load current mainly in a direction parallel to a main surface of the respective semiconductor power die 120. Horizontal semiconductor devices (which are also referred to as lateral semiconductor device in the art) may have bond pads 122 (only) at the upper surface of the power die 120.

As an example, the power die 120 may be a GaN power die, e.g., a GaN power transistor, in particular a GaN HEMT (high electron mobility transistor). As will be described in more detail further below, in this and other examples, the power die 120 may have at least one source (S) bond pad 122, at least one drain (D) bond pad 122 and a gate (G) bond pad 122 at its upper surface.

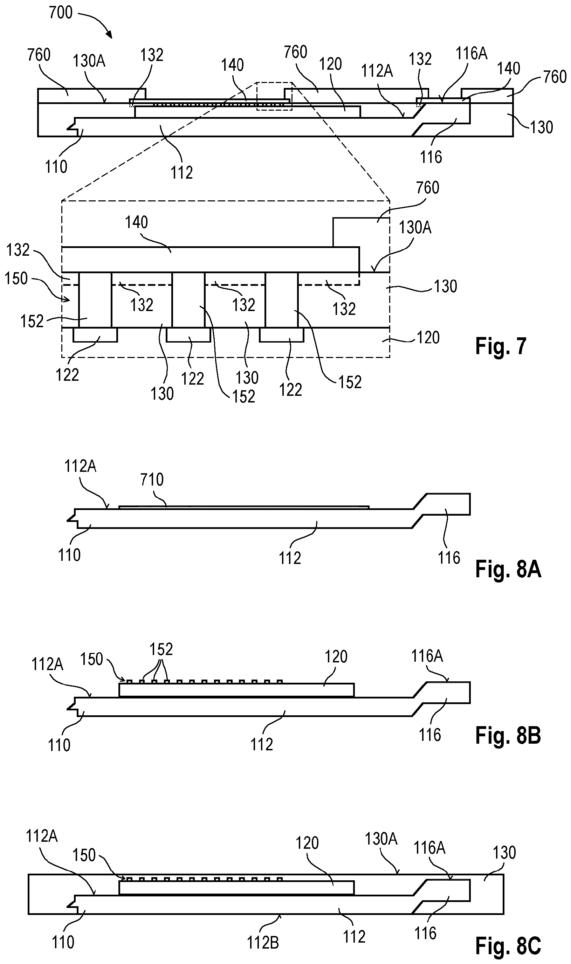

Figure 7 illustrates a cross-sectional view of an example of a molded power die package 700 which is implemented in accordance with the molded power die package 100, 200 described above.

In some examples, the molded power die package 700 may include a leadframe 110. The power die 120 is mounted on a carrier section (die pad or paddle) 112 of the leadframe 110. Further, in this example, the molded power die package 700 includes a laser-activatable mold compound 130 in which the power die 120 is embedded.

The power die 120 includes a plurality of bond pads 122. The bond pads 122 are electrically connected by a bond pad interconnect 150 to metal pads and/or metal traces 140 disposed at an upper side or outer surface 130A of the laser-activatable mold compound 130.

For forming the metal pads and/or metal traces 140, the laser-activatable mold compound has a plurality of laser-activated regions 132. The laser-activated regions 132 of the laser-activatable mold compound 130 are plated with a metal material which forms the metal pads and/or metal traces 140.

Any type of bond pad interconnect 150 as describe above may be used. In Figure 7, the bond pad interconnect 150 is exemplified by contact structures 152, which, for ease of illustration, are only schematically illustrated as connections between the metal pads and/or metal traces 140 and the bond pads 122. These contact structures 152 may be implemented in accordance with the first example (Escargot type contact structure 152 as shown in Figures 1A-1B, 3A-3E, 4). However, in other examples, the contact structures 152 of the bond pad interconnect 150 may be implemented in accordance with the second example (wavy-line type contact structures 252, 254 as shown in Figures 2A-2B, 5A-5E, 6) of the disclosure, i.e. by using bumps 252 and longitudinally extended electrically conductive elements 254 connected to bumps 252 disposed on the bond pads 122. In view of all these possibilities, reference is made to the above description to avoid reiteration.

In other words, any type of the aforementioned contact structures 152 or 252, 254 may be used in the bond pad interconnect 150. In the following description, without loss of generality, contact structures 152 are used for explanatory purposes.

The leadframe 110 includes a carrier section 112. It may further include a carrier interconnect section 116. The power die 120 is mounted on the carrier section 112 (so-called die pad or paddle of the leadframe 110).

The carrier interconnect section 116 may be integral with the carrier section 112 and may connect the carrier section 112 to metal pads and/or metal traces 140 at the outer surface 130A of the laser-activatable mold compound 130. To this end, as shown in Figure 7, an upper surface 116A of the carrier interconnect section 116 may be at a height that is elevated relative to an upper surface 112A of the carrier section 112.

The metal pads and/or metal traces 140 may be used for electrical redistribution and/or for package input/output (I/O), e.g., as external package terminals of the package 700. In this case, the bond pad interconnect 150 formed by the plurality of contact structures 152 and (optionally) the protruded leadframe interconnect formed by the carrier interconnect section 116 may connect to the metal pads and/or metal traces 140 at the forming the package input/output (I/O).

The leadframe 110 may form a heat sink of the molded power die package 700. As the leadframe 110 may be at a load terminal (e.g. source) potential in operation, it can act to prevent strong dynamic R_{DS(on)} (on-resistance) and current collapse during operation as experienced in packages in which the die carrier is electrically floating.

As will be described in more detail further below, the above concept may simplify the process of manufacturing a molded power die package 700 having a leadframe 110, a power die 120 and a laser-activatable mold compound 130 used for fabricating the metal pads and/or metal traces 140 for I/O connectivity of the power die package 700. In particular, no separate parts and no bonding material (e.g., solder paste, electrically conductive glue material) are needed to connect the leadframe 110 at the bottom of the package 700 to the top side of the package 700. Further, due to the integral design of the leadframe 110 including the carrier section 112 and the carrier interconnect section 116, the power die package 700 may exhibit advanced reliability and robustness.

In some examples, the carrier interconnect section 116 may be an edge part of the leadframe 110. The elevated height of the carrier interconnect section 116 relative to the upper surface 112A of the carrier section 112 may, e.g., be provided by a bending or stamping process. For example, an edge part of the leadframe 110 is stamped-up or bent-up during leadframe fabrication to provide the elevated carrier interconnect section 116 of the leadframe 110.

As shown in Figure 7, in some examples, the upper ends (e.g., the exposed areas 152A) of the contact structures 152 may be at the same height as the upper surface 116A of the carrier interconnect section 116. Further, the upper ends of the contact structures 152 and the upper surface 116A of the carrier interconnect section 116 may be at the same height as the outer surface 130A of the laser-activatable mold compound 130, for example. That way, the metal pads and/or metal traces 140 may be generated simultaneously on the laser-activated regions 132 of the laser activatable mold compound 130, the exposed upper ends the vertical contact structures 152 and, e.g., the upper surface 116A of the carrier interconnect section 116. The same applies to the upper ends (e.g., the exposed areas 254A) of the contact structures 252, 254.

An isolation layer 760 may be applied over the metal pads and/or metal traces 140 and (non-activated regions of) the outer surface 130A of the laser-activatable mold compound 130. As shown in Figure 7, the isolation layer 760 may be structured to expose portions (e.g., terminal pad portions) of the metal pads and/or metal traces 140. The isolation layer 760 may be applied by a printing process.

Figures 8A-8F are cross-sectional views illustrating stages of manufacturing the molded power die package 700. Referring to Figure 8A, the leadframe 110 including the carrier section 112 and, e.g., the carrier interconnect section 116 protruding in vertical direction from the carrier section 112 is provided.

As further shown in Figure 8A, a bonding material 710 may be disposed on the upper surface 112A of the carrier section 112. The bonding material 710 may, e.g., include a solder paste or a glue material. The bonding material 710 may be applied to the upper surface 112A of the leadframe 110 by a printing process, e.g., by screen printing. In the following Figures 8B to 8F, for ease of illustration, the bonding material 710 is not shown.

Referring to Figure 8B, the power die 120 is placed on the carrier section 112 of the leadframe 110. As mentioned before, the power die 120 has a plurality of bond pads 122 (see Figure 1) facing away from the carrier section 112.

Still referring to Figure 8B, the bond pad interconnect 150 is attached to the plurality of bond pads 122 of the power die 120 (see the description above). The bond pad interconnect 150 may be attached to the bond pads 122 before or after placing the power die 120 on the carrier section 112 of the leadframe 110.

Referring to Figure 8C, the power die 120 and the bond pad interconnect 150 are embedded in the laser-activatable mold compound 130 by a molding process. In the molding process, the leadframe 110 with the power semiconductor semiconductor die 120 mounted thereon may be placed in a molding cavity into which the liquid mold compound 130 is then introduced and cured.

As apparent from Figure 8C, the laser-activatable mold compound 130 may, e.g., completely cover the power die 120, the bond pad interconnect 150, the upper surface 112A of the carrier section 112 and/or the upper surface 116A of the carrier interconnect section 116. A lower surface 112B of the carrier section 112 may remain exposed, for example.

There are several possibilities to expose the bond pad interconnect 150 (e.g., upper ends of the contact structures 152 or 252, 254) and/or the upper surface 116A of the carrier interconnect section 116. In some examples, the laser-activatable mold compound 130 may be thinned to expose the bond pad interconnect 150 and/or the upper surface 116A. For example, the laser-activatable mold compound 130 may be thinned by grinding until the bond pad interconnect 150 (e.g., the upper ends of the contact structures 152 or 252, 254) and/or the upper surface 116A is exposed.

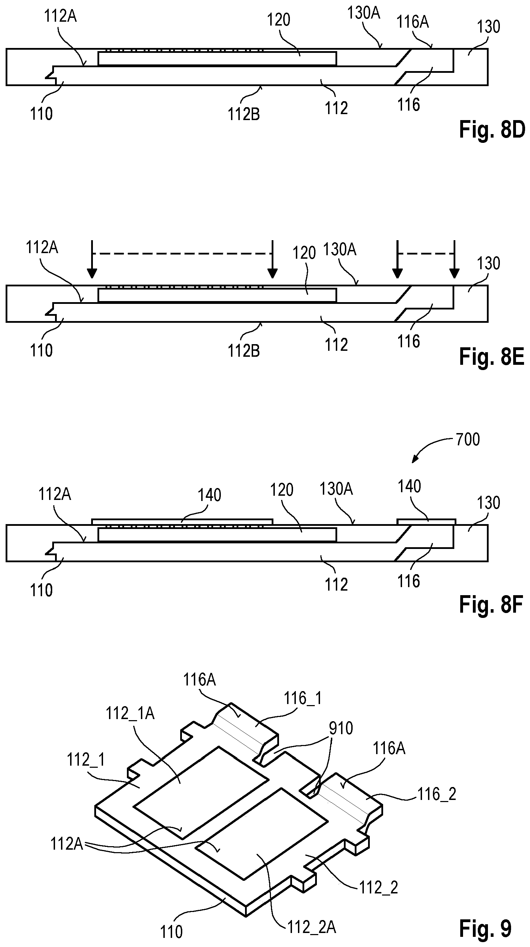

Figure 8D illustrates the structure of Figure 8C after thinning the laser-activatable mold compound 130.

In other examples, the bond pad interconnect 150 (e.g., the upper ends of the contact structures 152) and/or at least parts of the upper surface 116A of the carrier interconnect section 116 may be exposed by drilling (e.g., mechanical drilling) or laser ablation (e.g., laser drilling) of the laser-activatable mold compound 130. In this case, the bond pad interconnect 150 and/or the upper surface 116A of the carrier interconnect section 116 may only be slightly over-molded by, e.g., a thickness of about 5 to 20 µm. In this case, the thinning process illustrated by Figure 8D may be skipped.

In other examples, the molding process may be carried out to provide an outer surface 130A of the laser-activatable mold compound 130 at which the bond pad interconnect 150 (e.g., the upper ends of the contact structures 152) and/or the upper surface 116A of the carrier interconnect section 116 are exposed. For example, an elastic element (e.g., rubber element) may be placed in the mold to prevent the laser-activatable mold compound 130 from fully encasing (over-molding) the bond pad interconnect 150 and/or the upper surface 116A of the carrier interconnect section 116. This way, thinning or drilling of the laser-activatable mold compound 130 to expose the bond pad interconnect 150 and/or the upper surface 116A of the carrier interconnect section 116 may be avoided. In this case, Figure 8C illustrating an over-mold process may be skipped and the molding process may directly arrive at the structure shown in Figure 8D, for example.

Referring to Figure 8E, a laser is directed at an outer surface 130A of the laser-activatable mold compound 130 to laser-activate a plurality of regions 132 (see Figure 7) of the laser-activatable mold compound 130. The downward-facing arrows indicate a laser beam directed towards the laser-activatable mold compound 130 with exposed bond pad interconnect 150 and/or exposed upper surface 116A of the carrier interconnect section 116. By laser activation, metal atoms may be freed to act as nuclei for metal or metal alloy (e.g., Cu, Ni, NiP, Au, Cu/Ni/Au stack, etc.) at or in the laser-activated regions 132 of the laser-activatable mold compound 130.

Suitable polymers for such LDS of the laser-activatable mold compound 130 may include, but are not limited to, thermoset polymers having a resin base, ABS (acrylonitrile butadiene styrene), PC/ABS (polycarbonate / acrylonitrile butadiene styrene), PC (polycarbonate), PA/PPA (polyimide / polyphthalamide), PBT (polybutylene terephthalate), COP (cyclic olefin polymer), PPE (polyphenyl ether), LCP (liquid-crystal polymer), PEI (polyethylenimine or polyaziridine), PEEK (polyether ether ketone), PPS (polyphenylene sulfide), etc.

The term "laser-activated regions" 132 as used herein may mean regions of the laser-activatable mold compound 130 which have already been activated by a laser beam, as opposed to a laser-activatable region of the mold compound 130 which is capable of being activated by laser light but has yet to actually be activated. The process to form the laser-activated regions 132 may be referred to as LDS.

Referring to Figure 8F, a metal material is plated on the plurality of laser-activated regions 132 of the laser-activatable mold compound 130 to form the metal pads and/or metal traces 140. Hence, the metal pads and/or metal traces are structured directly on the mold compound 130 without having to use a sophisticated and expensive leadframe. Further, the molded power die package 700 may be fabricated with a footprint of high design variability, as the footprint design (design of package terminals) can be chosen by laser illumination (e.g., LDS).

Accordingly, the distance between the active circuit and the package I/O (inputs/outputs) is controllable to minimize parasitic electric effects. Also, the metal pads and/or metal traces 140 which may be realized with this approach yield greater design freedom in that the bond pad interconnect 150 is not required to necessarily reside inside the footprint of a package terminal metal pad as is the case with a leadframe-type approach.

Figures 9 to 15B illustrate, by way of example, molded power die packages 1100, 1300 containing two or more power dies 120. Generally, molded power die packages 700, 1100, 1300, as described herein, may contain one, two or more power dies 120. Any disclosure below may also relate to a single power die package 700 or to a multiple power die package 1100, 1300. Further, any disclosure below may also relate to a molded power die package 100 as described in connection with Figures 1 to 6.

Referring to Figure 9, a leadframe 110 may include a first carrier section 112_1 and second carrier section 112_2, each having an upper surface 112A which may be at the same height. Further, the leadframe 110 may include a first carrier interconnect section 116_1 integral with the first carrier section 112_1 and a second carrier interconnect section 116_2 integral with the second carrier section 112_2. The upper surface 116A of the first carrier interconnect section 116_1 may be at the same height as the upper surface 116A of the second carrier interconnect section 116_2.

As illustrated in Figure 9, the first carrier interconnect section 116_1 and the second carrier interconnect section 116_2 may be separated from each other. More specifically, the upper surface 116A of the first carrier interconnect section 116_1 may be disconnected from the upper surface 116A of the second carrier interconnect section 116_2.

For example, the leadframe 110 may be provided with at least one recess 910 at the edge of the leadframe 110 at which the carrier interconnect sections 116_1, 116_2 are formed. For example, two recesses 910 may be formed at the edge of the leadframe 110 between the first and the second carrier interconnect sections 116_1, 116_2. The part of the leadframe 110 between the two recesses 910 may level with the (e.g., continuous) carrier sections 112_1, 112_2 of the leadframe 110.

In some examples the only parts of the leadframe 110 having an upper surface at a height that is elevated relative to the upper surface 112A of the carrier section(s) 112, 112_1, 112_2 of the leadframe 110, may be the carrier interconnect section(s) 116, 116_1, 116_2. The leadframe 110 may be produced by stamping-up or bending-up only the one or more carrier interconnect section(s) 116, 116_1, 116_2.

Figure 9 further shows a die pad zone 112_1A of first carrier section 112_1 and a die pad zone 112_2A of second carrier section 112_2. The die pad zones 112_1A, 112_2A may have been subjected to a surface treatment to provide a high quality surface for die bonding. For example, the die pad zones 112_1A, 112_2A may be selectively plated areas. As a specific example, the die pad zones 112_1A, 112_2A may be Ag plated areas for a glue bond die attach process.

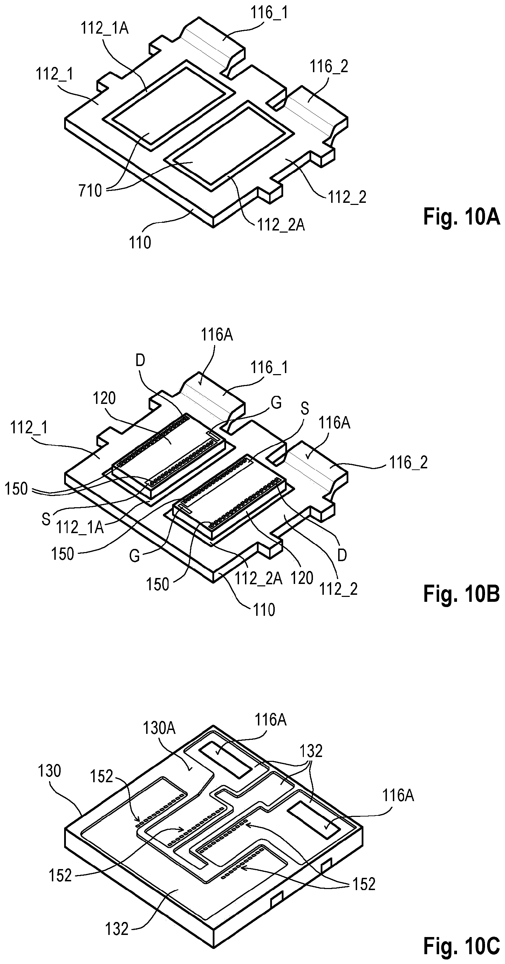

Referring to Figure 10A, a bonding material 710 may be applied to the first carrier section 112_1 and the second carrier section 112_2. Reference is made to Figure 8A to avoid reiteration.

Referring to Figure 10B, power dies 120 are placed on and bonded to the leadframe 110. Bond pads S (source), D (drain) and G (gate) may be provided at the upper sides of the power dies 120. As shown in Figure 10B, the bond pad interconnect 150 formed, e.g., by vertical contact structures 152 (or, alternatively, bumps 252 and conductive elements 254 - not shown) may already be provided on the bond pads S, D, G of the power die 120. For example, the power dies 120 are GaN transistors, e.g. GaN HEMTs. Reference is made to Figure 8B to avoid reiteration.

Figure 10C illustrates the structure of Figure 10B after over-molding (Figures 8C, 8D) and LDS (e.g., Figure 8E) to form the laser-activated regions 132. As described above, the upper ends of the vertical contact structures and, e.g., the upper surfaces 116A of the carrier interconnect sections 116_1, 116_2 may be exposed.

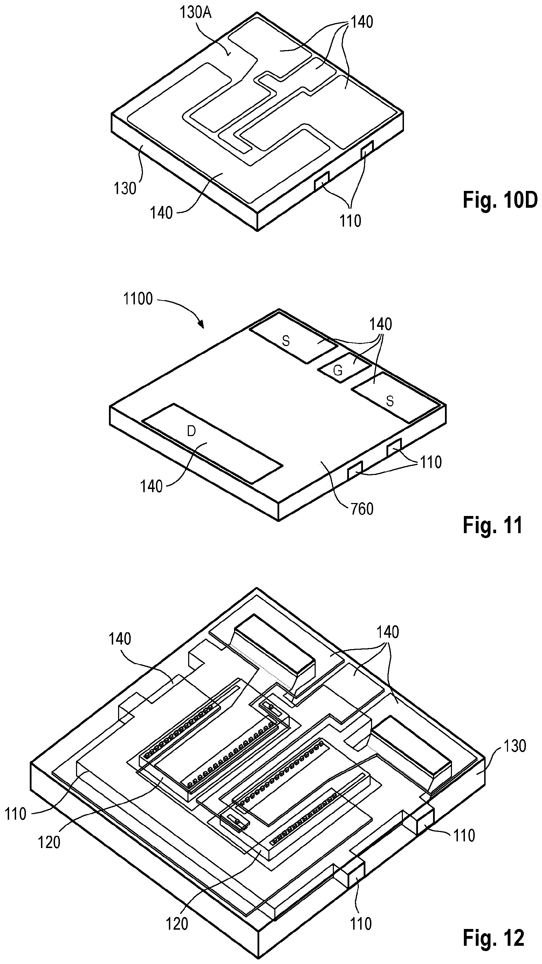

Figure 10D illustrates the structure of Figure 10C after plating the metal material on the laser-activated regions 132 to form the metal pads and/or metal traces 140. Reference is made to Figure 8F to avoid reiteration.

Referring to Figure 11, an isolation layer 760 may be applied over the metal pads and/or metal traces 140 and the (non-activated regions of) outer surface 130A of the laser-activatable mold compound 130. The isolation layer 760 may be structured to expose metal pads (e.g., S, D, G) of the metal pads and/or metal traces 140 of the molded power die package 1100. The isolation layer 760 may, e.g., be a solder mask layer and/or comprise a solder stop material applied as a layer. (Exposed) metal pads 140 may form external terminals of the molded power die package 1100. The metal pads 140 may be configured to be soldered to, e.g., an application board (not shown) on which the molded power die package 1100 is to be mounted. Further, as the carrier section 112 (or first and second carrier sections 112_1, 112_2) operating as a heat sink is typically on source (S) potential for the reasons set out above, it may be possible for an end user (depending on his choice) to use the (e.g., exposed) lower surface 112B of the carrier section 112 as a source (S) terminal of the molded power die package 1100.

Figure 12 illustrates a perspective semi-transparent view of the molded power die package 1100 of Figure 5 (the isolation layer 760 is not shown).

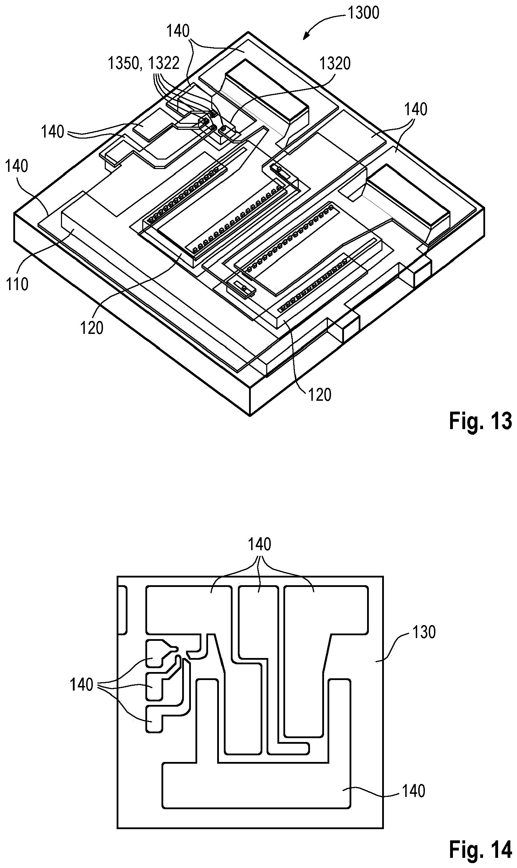

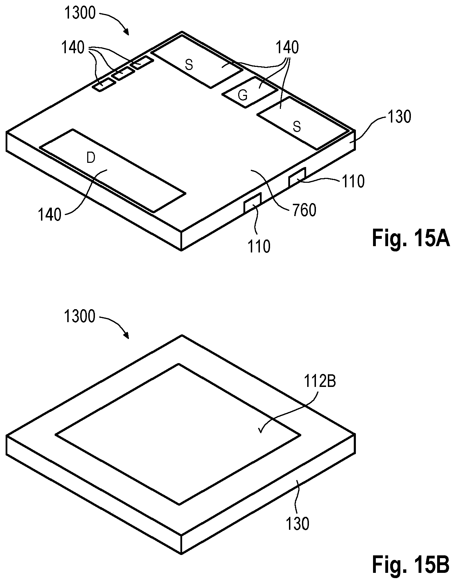

Referring to Figure 13, a molded power die package 1300 may include a gate driver die 1320. The molded power die package 1300 may be similar to the molded power die package 1100 except that the gate driver die 1320 is included and a gate driver die interconnect between the gate driver die 1320 and the power dies 120 is provided by the metal pads and/or metal traces 140, i.e. by LDS and metal plating. Further, the metal pads and/or metal traces 140 may provide for additional metal pads used as package terminals (Figure 15A). The gate driver die 1320 may be embedded in the laser-activatable mold compound 130. The gate driver die 1320 may have a plurality of gate driver bond pads 1322.

The molded power die package 1300 may further include a gate driver bond pad interconnect 1350. The gate driver bond pad interconnect 1350 may electrically connect the plurality of gate driver bond pads 1322 to the metal pads and/or metal traces 140 at the outer surface 130A of the laser-activatable mold compound 130. The gate driver bond pad interconnect 1350 may, e.g., be provided by vertical interconnect structures such as, e.g., contact structures 152 or 252, 254, i.e. by the same vertical contact structures as used for the bond pad interconnect 150, for example.

Figure 14 is a top view on the outer surface 130A of the mold compound 130 after plating metal material on the laser-activated regions 132 to form the metal pads and/or metal traces 140 of the power die package 1300.

Figure 15A is a perspective view on a top side of the power die package 1300. As apparent from Figure 15A, metal pads 140 connecting to the gate driver die 1320 are exposed on the top side of the molded power die package 1300. The isolation layer 760 may be used to define the exposed areas of the metal pads 140, i.e. for footprint definition.

Figure 15B illustrates a bottom side of the power die package 1300. As mentioned before, the lower surface 112B of the carrier section 112 (including, e.g., the first and second carrier sections 112_1, 112_2) may be exposed at the bottom side of the package 1300 (and, likewise, at the bottom side of other packages 100, 200, 1100, etc.). That is, in this and all other examples disclosed herein, the power die package 1300 may be a double-side cooled package (DSC package).

In all examples, a multiple layer laser-activatable mold compound 130 may be used instead of the single layer mold compound 130 as exemplified above. When using a multiple layer laser-activatable mold compound, each layer of the multiple layer mold compound 130 is individually molded, laser-activated and plated during the process of manufacturing a multiple layer mold compound package. That way, the bond pad interconnect 150 may be generated mold compound layer-by-mold compound layer.

Further, one or more LDS processes and plating processes may be applied to a single layer or each layer of the laser-activatable mold compound 130.

While requiring multiple molding processes and/or multiple LDS and plating processes, a package realized with such multi-layer mold compound approach may yield still greater design freedom in terms of package I/O connectivity.

Further, a layer of a laser-activatable mold compound 130 (single layer or multi-layer) may be plated by a single LDS and single plating process (as exemplarily described above) or by a multi-LDS and multi-plating processes.

The molded power die packages 100, 200, 700, 1100, 1300 described herein may be configured as switches for high current applications, e.g. for switching load currents equal to or greater than 50 A, 100 A, or 150 A. That is, the (vertical) contact structures 152 or 252, 254 of the bond pad interconnect 150 has a routing capability to carry such currents.

Moreover, the bond pad interconnect 150, and in particular the (vertical) contact structures 152 or 252, 254, may be implemented without the use of solder, i.e. may be a solder-free interconnect.

### EXAMPLES

The following examples pertain to further aspects of the disclosure:
Example 1 is a power die package, including a power die having a plurality of bond pads at an upper surface of the power die; a plurality of contact structures, wherein a contact structure comprises: (A) a bond wire bonded to one of the plurality of bond pads and folded back to the bond pad to form a closed loop; or (B) at least three bumps laterally spaced from one another and disposed on one or more bond pads, and a continuous longitudinally extended electrically conductive element connected to the at least three bumps in at least three contact positions, wherein the conductive element bends away from the power die between pairs of consecutive contact positions; a mold compound partially encapsulating the contact structure, wherein the mold compound comprises an outer surface facing away from the power die, and wherein the contact structure is partially exposed at the outer surface.
In Example 2, the subject matter of Example 1 can optionally include wherein the mold compound is a laser-activatable mold compound which has at least one laser-activated region which is plated with a metal material to form a metal pad and/or a metal trace at the outer surface of the mold compound, and the contact structure connects to the metal material.
In Example 3, the subject matter of Example 2 can optionally include wherein the metal material has a thickness in a range between 30 µm and 100 µm.
In Example 4, the subject matter of Example 2 or 3 can optionally include wherein the area of the outer surface covered by plated metal material amounts to at least 50% of the area of the outer surface.
In Example 5, the subject matter of any of the preceding Examples can optionally include wherein a height of the contact structure is in a range between 70 µm and 200 µm.
In Example 6, the subject matter of any of the preceding Examples can optionally include wherein the power die is a horizontal semiconductor device having the plurality of bond pads only at the upper surface.
In Example 7, the subject matter of any of the preceding Examples can optionally further include a leadframe comprising a carrier section on which the power die is mounted, wherein the upper surface of the power die faces away from the carrier section.
In Example 8, the subject matter of any of the preceding Examples can optionally include wherein the power die comprises a GaN transistor, in particular a GaN high electron mobility transistor.
In Example 9, the subject matter of any of the preceding Examples can optionally include wherein the electrically conductive element is a bond wire or a bond ribbon.
In Example 10, the subject matter of Example 9 can optionally further include a gate driver die having a plurality of gate driver bond pads at an upper surface of the gate driver die; and a plurality of gate driver contact structures, wherein a gate driver contact structure is bonded to one of the plurality of gate driver bond pads and is partially exposed at the outer surface of the mold compound.
In Example 11, the subject matter of any preceding Example can optionally include wherein the gate driver contact structure comprises a bond wire bonded to the one of the plurality of gate driver bond pads and folded back to the gate driver bond pad to form a closed loop.
Example 12 is a method comprising providing a power die having a plurality of bond pads at an upper surface of the power die; bonding a plurality of contact structures to the plurality of bond pads of the power die, wherein a contact structure comprises: (A) a bond wire which is bonded to one of the plurality of bond pads and folded back to the bond pad to form a closed loop; or (B) at least three bumps laterally spaced from one another and disposed on one or more bond pads, and a continuous longitudinally extended electrically conductive element which is connected to the at least three bumps in at least three contact positions, wherein the conductive element bends away from the power die between pairs of consecutive contact positions; and embedding the power die and the plurality of contact structures in a mold compound such that the mold compound partially encapsulates the contact structure which is partially exposed at an outer surface of the mold compound facing away from the power die.
In Example 13, the subject matter of Example 12 can optionally include wherein the mold compound is a laser-activatable mold compound, the method further comprising: directing a laser to the outer surface of the mold compound to laser-activate a plurality of regions of the mold compound; and plating a metal material on the plurality of laser-activated regions of the mold compound to form a metal pad and/or a metal trace at the outer surface of the mold compound, wherein the contact structure connects to the metal material.
In Example 14, the subject matter of Example 12 or 13 can optionally include wherein bonding a plurality of contact structures to the plurality of bond pads according to (B) comprises: attaching the at least three bumps to the one or more bond pads; and attaching a bond wire as the continuous longitudinally extended electrically conductive element to the at least three bumps using a capillary for bond wire dispensing.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A power die package, comprising:
a power die having a plurality of bond pads at an upper surface of the power die;
a plurality of contact structures, wherein a contact structure comprises:
(A) a bond wire bonded to one of the plurality of bond pads and folded back to the bond pad to form a closed loop; or
(B) at least three bumps laterally spaced from one another and disposed on one or more bond pads, and
a continuous longitudinally extended electrically conductive element connected to the at least three bumps in at least three contact positions, wherein the conductive element bends away from the power die between pairs of consecutive contact positions;
a mold compound partially encapsulating the contact structure, wherein the mold compound comprises an outer surface facing away from the power die, and wherein the contact structure is partially exposed at the outer surface.

2. The power die package of claim 1, wherein
the mold compound is a laser-activatable mold compound which has at least one laser-activated region which is plated with a metal material to form a metal pad and/or a metal trace at the outer surface of the mold compound, and
the contact structure connects to the metal material.

3. The power die package of claim 2, wherein the metal material has a thickness in a range between 30 µm and 100 µm.

4. The power die package of claim 2 or 3, wherein the area of the outer surface covered by plated metal material amounts to at least 50% of the area of the outer surface.

5. The power die package of any of the preceding claims, wherein a height of the contact structure is in a range between 70 µm and 200 µm.

6. The power die package of any of the preceding claims, wherein the power die is a horizontal semiconductor device having the plurality of bond pads only at the upper surface.

7. The power die package of any of the preceding claims, further comprising:
a leadframe comprising a carrier section on which the power die is mounted, wherein the upper surface of the power die faces away from the carrier section.

8. The power die package of any of the preceding claims, wherein the power die comprises a GaN transistor, in particular a GaN high electron mobility transistor.

9. The power die package of any of the preceding claims, wherein the electrically conductive element is a bond wire or a bond ribbon.

10. The power die package of any of the preceding claims, further comprising:
a gate driver die having a plurality of gate driver bond pads at an upper surface of the gate driver die; and
a plurality of gate driver contact structures, wherein a gate driver contact structure is bonded to one of the plurality of gate driver bond pads and is partially exposed at the outer surface of the mold compound.

11. The power die package of claim 10, wherein the gate driver contact structure comprises a bond wire bonded to the one of the plurality of gate driver bond pads and folded back to the gate driver bond pad to form a closed loop.

12. A method of manufacturing a power die package, the method comprising:
providing a power die having a plurality of bond pads at an upper surface of the power die;
bonding a plurality of contact structures to the plurality of bond pads of the power die, wherein a contact structure comprises:
(A) a bond wire which is bonded to one of the plurality of bond pads and folded back to the bond pad to form a closed loop; or
(B) at least three bumps laterally spaced from one another and disposed on one or more bond pads, and a continuous longitudinally extended electrically conductive element which is connected to the at least three bumps in at least three contact positions, wherein the conductive element bends away from the power die between pairs of consecutive contact positions; and
embedding the power die and the plurality of contact structures in a mold compound such that the mold compound partially encapsulates the contact structure which is partially exposed at an outer surface of the mold compound facing away from the power die.

13. The method of claim 12, wherein the mold compound is a laser-activatable mold compound, the method further comprising:
directing a laser to the outer surface of the mold compound to laser-activate a plurality of regions of the mold compound; and
plating a metal material on the plurality of laser-activated regions of the mold compound to form a metal pad and/or a metal trace at the outer surface of the mold compound, wherein the contact structure connects to the metal material.

14. The method of claim 12 or 13, wherein bonding a plurality of contact structures to the plurality of bond pads according to (B) comprises:
attaching the at least three bumps to the one or more bond pads; and
attaching a bond wire as the continuous longitudinally extended electrically conductive element to the at least three bumps using a capillary for bond wire dispensing.
